# EUROPÄISCHE PATENTSCHRIFT

(11) **EP 2 881 997 B1**
(45) Veröffentlichungstag und Bekanntmachung des Hinweises auf die Patenterteilung: **22.03.2017**
(21) Anmeldenummer: 13005690.6
(22) Anmeldetag: 06.12.2013
(51) Int. Cl.: H02S 40/22, H01L 31/042

(54) **Anordnung zur Nutzung von Sonnenenergie**
Assembly for using solar energy
Système d'utilisation de l'énergie solaire

(43) Veröffentlichungstag der Anmeldung: 10.06.2015
(73) Patentinhaber: Däbritz, Michael, 75417 Mühlacker (DE)
(72) Erfinder: Däbritz, Michael, 75417 Mühlacker (DE)
(74) Vertreter: Schön, Thilo

(56) Entgegenhaltungen:
- EP-A2- 2 418 692
- WO-A2-2009/105268
- US-A1- 2013 312 812

## Beschreibung

Die Erfindung betrifft eine Anordnung zur Nutzung von Sonnenenergien nach dem Oberbegriff des Anspruchs 1.

Solarmodule, insbesondere Photovoltaik-Solarmodule sind seit langem bekannt und werden in großer Anzahl eingesetzt, um aus Sonnenstrahlung eine Nutzenergie - im Fall von Photovoltaik-Solarmodulen elektrische Energie - zu erzeugen. Häufig weist eine Solaranlage eine Vielzahl solcher Module auf. Insbesondere wenn eine solche Solaranlage auf einem flachen Untergrund wie einem Flachdach oder einer im Wesentlichen ebenen Freifläche aufgestellt wird, erfolgt die Anordnung der Solarmodule wie folgt: Mehrere Solarmodul werden zu einer Reihe zusammengefügt, sodass die zur Sonne weisenden Oberflächen der Solarmodule dieser Reihe sämtlich im Wesentlichen in einer Ebene liegen.

Der Horizontalanteil der Flächennormalen dieser Ebene weist im Wesentlichen nach Sonden, vorzugsweise genau nach Süden. Dies gilt natürlich nur für die Nordhalbkugel, insbesondere nördlich des nördlichen Wendekreisel: auf der Südhalbkugel, insbesondere südlich des südlichen Wendekreises gilt natürlich das Umgekehrte - hier sind die Solarmodule entsprechend nach Norden ausgerichtet. Zwischen den Wendekreisen, insbesondere nahe des Äquators weisen die Flächennormalen der Solarmodule vorzugsweise senkrecht nach oben. Da sich die Erfindung auf Situationen bezieht, bei denen die Flächennormale des Solarmoduls nicht senkrecht nach oben zeigt, wird im Weiteren nur noch hierauf Bezug genommen, wobei im Weiteren ausschließlich von der Situation auf der Nordhalbkugel gesprochen wird; für die Südhalbkugel gilt jedoch das Entsprechende. Die Solarmodul sind gegen die Horizontale um einen ersten Winkel geneigt, wobei der Idealwert dieses ersten Winkels vom Breitengrad abhängt in Süddeutsch land beträgt er beispielsweise ca 32° Grad. Somit weist jedes Solarmodul ein unteres (südliches) und ein oberes (nördliches) Ende auf.

In der Regel sind mehrere solcher Reihen vorhanden, wobei sämtliche Solarmodule zueinander parallel sind und wobei die Reihen voneinander beabstandet sind, um Abschattungen (auch in den Frühjahrs-, Herbst- und Wintermonaten) zu vermeiden. D.h., dass die Reihen einen relativ großen Abstand (in Nord-Süd-Richtung) voneinander haben, wobei der Abstand in Nord-Süd-Richtung in etwa der Vertikalprojektion der Nord-Süd-Erstreckung eines Solarmoduls entspricht. Mit anderen Worten: zwischen den Reihen ist relativ viel Platz vorhanden.

Es besteht natürlich stets der Wunsch, den Gesamtwirkungsgrad einer Solaranlage zu erhöhen, d.h. den Gesamtjahres-Energieertrag bei gegebener zur Verfügung stehender Fläche zu steigern. Hierzu gibt es grundsätzlich mehrere Möglichkeiten: zum einen ist es möglich, die einzelnen Solarmodule der Sonne nachzuführen, um so immer einen (mehr oder weniger) idealen senkrechten Strahlungseinfall auf das Modul zu erzielen. Da solche Systeme jedoch extrem aufwendig in Herstellung und Wartung sind, wird dieser Weg kaum mehr beschritten; vielmehr sind die Solarmodule fast immer feststehend verbaut Der andere Weg besteht darin, den Wirkungsgrad der Solarmodule selbst zu erhöhen, insbesondere durch Optimierung der verwendeten Halbleiter.

Aus der gattungsbildenden WO 2009/105268 A3 ist eine Anordnung mit einem flächigen, im Wesentlichen ebenen Solarmodul zur Umwandlung von Sonnenstrahlung in eine Nutzenergie bekannt. Hierbei definiert die Oberfläche des Solarmoduls eine erste Ebene, welche gegen die Horizontale um einen ersten Winkel geneigt ist, so dass das Solarmodul ein oberes Ende und ein unteres Ende aufweist. Benachbart zum unteren Ende des Solarmoduls ist ein aus einem durchsichtigen Material bestehender Reflektor angeordnet, welcher sich von einem dem unteren Ende des Solarmoduls benachbarten ersten Ende vom Solarmodul weg erstreckt. Der Reflektor weist eine nach oben weisende obere Oberfläche und eine nach unten weisende untere Oberfläche auf, wobei die obere Oberfläche gerippt mit einer Mehrzahl von ersten Rippen ausgebildet ist, wobei jede erste Rippe eine dem Solarmodul zugewandte erste Oberfläche und eine dem Solarmodul abgewandte zweite Oberfläche aufweist. Hierdurch wird die auf das Solarmodul auftreffende Gesamtmenge an Sonnenlicht gesteigert.

Hiervon ausgehend stellt sich die vorliegende Erfindung die Aufgabe, den Ertrag einer Solaranlage mit wenigstens einem starr ausgerichteten Solarmodul weiter zu erhöhen. Hierbei soll insbesondere auch die Möglichkeit bestehen, bestehende Solaranlagen nachzurüsten. Weiterhin soll die Maßnahme zur Effizienzsteigerung kostengünstig in Anschaffung und Wartung sein.

Diese Aufgabe wird durch eine Anordnung mit den Merkmalen des Anspruchs 1 gelöst.

Die Erfindung geht von der allgemein bekannten Tatsache aus, dass die Energieausbeute eines wie oben dargestellt feststehenden Solarmoduls um die Mittagszeit am höchsten ist und der Ertrag zu Beginn des Tages und zum Ende des Tages stark abfällt. Dies hängt insbesondere mit dem Einstrahlungswinkel der Sonne zusammen, welcher naturgemäß um die Mittagszeit am günstigsten ist. Das eben Gesagte gilt für alle Jahreszeiten.

Es wird deshalb ein Reflektor zur Verfügung gestellt, welcher sich benachbart zum unteren Ende des Solarmoduls erstreckt und welcher aus einem durchsichtigen Material, wie beispielsweise PMMA (Plexiglas) oder Polycarbonat (PC) besteht. Dieser Reflektor ist jedoch nicht so ausgestaltet, dass er das Sonnenlicht wie ein Spiegel reflektiert, da ein solcher Spiegel nur sehr wenig zusätzliches Sonnenlicht auf das Solarmodul lenken würde. Der Reflektor ist vielmehr so ausgebildet, dass er einen großen Teil des Lichtes, welches einen starken Ost-West- oder West-Ost-Richtungsanteil hat, einfängt und durch Reflektion, Totalreflektion und Brechung zu einem großen Teil gerichtet in Richtung des vor ihm liegenden Solarmoduls abstrahlt. Dies wird dadurch erreicht, dass die nach oben weisende Oberfläche (im Folgenden: obere Oberfläche) des Reflektors gerippt mit einer Mehrzahl von vorzugsweise prismenförmigen Rippen ausgebildet ist. Diese Rippen (erste Rippen) weisen jeweils eine dem Solarmodul zugewandte erste Oberfläche und eine dem Solarmodul abgewandte zweite Oberfläche auf- Im Prinzip können diese Rippen, welche sich vorzugsweise sämtlich parallel zueinander in Ost-West-Richtung erstrecken, mehr oder weniger beliebig geformt sein, um einen messbaren Effekt zu erzielen. Es gibt jedoch bestimmte geometrische Gegebenheiten, welche sowohl hinsichtlich einer maximalen Effektivität als auch hinsichtlich einer einfachen Herstellbarkeit des Reflektors zu bevorzugen sind. Zu diesen geometrische Gegebenheiten gehören insbesondere Folgende: Alle Rippen sind gleich ausgebildet und erstrecken sich parallel zueinander; alle erste Oberflächen der Rippen sind eben und parallel zueinander; alle zweite Oberflächen der Rippen sind eben und parallel zueinander. Idealerweise sind alle diese Bedingungen gleichzeitig erfüllt, insbesondere in verschlechterten Ausführungsformen der Erfindung könnten jedoch einzelne dieser Bedingungen nicht erfüllt sein, insbesondere könnten mehrere unterschiedlich geformte Rippentypen vorgesehen sein.

Der Reflektor weist auch eine nach unten weisende Oberfläche auf. Erfindungsgemäß ist vorgesehen, auch diese nach unten weisende Oberfläche (im Folgenden: untere Oberfläche) des Reflektors gerippt mit einer Mehrzahl von zweiten Rippen auszubilden, wobei auch diese Rippen vorzugsweise Prismen mit einer dritten und einer vierten Oberfläche bilden, wobei auch hier die Rippen vorzugsweise Dreiecke sind. Auch diese Rippen erstrecken sich vorzugsweise sämtlich parallel zueinander, nämlich parallel zu den ersten Rippen. Eine weitere Erhöhung des Wirkungsgrades wird vorzugsweise durch eine reflektierende Beschichtung der unteren Oberfläche erreicht.

Vorzugsweise nach Anspruch 3 definiert der Reflektor eine zweite Ebene (oder geometrisch genauer: eine zweite Schar von Ebenen, welche zueinander parallel sind), wobei diese Ebene bzw. Ebenen in einem zweiten Winkel gegen die Horizontale geneigt sind. Im oben genannten Ausführungsbeispiel (Nordhalbkugel) weist die obere Oberfläche des Reflektors somit in Richtung Norden. Der Betrag dieses zweiten Winkels liegt vorzugsweise in der gleichen Größenordnung wie der Betrag des ersten Winkels, in welchem das Solarmodul gegen die Horizontale geneigt ist, wobei er vorzugsweise etwas kleiner ist, beispielsweise zwischen 1° und 8° Grad, vorzugsweise um ca. 5° Grand.

Zwischen den ersten Rippen und den zweiten Rippen kann sich ein plattenförmiger Mittelabschnitt erstrecken, auf welchen die jeweiligen Rippen aufgesetzt" sind. Der Begriff "aufgesetzt" ist hierbei rein geometrisch zu verstehen, da zwischen den ersten Rippen und dem Mittelabschnitt und den zweiten Rippen und dem Mittelabschnitt keine geometrische Grenze besteht.

In der Regel ist es zu bevorzugen, dass die zweiten Oberflächen der ersten Rippen stärker gegen die zweite Ebene geneigt sind als die ersten Oberflächen, wobei es insbesondere zu bevorzugen ist, dass die zweiten Oberflächen im Wesentlichen senkrecht zur zweiten Ebene sind. Auch im Bezug auf die vierten Oberflächen der zweiten Rippen ist eine solche Ausrichtung zu bevorzugen.

Der beschriebene Reflektor wurde zwar mit dem Ziel entwickelt, die Energieausbeute von Solarmodulen zu erhöhen, andere Einsatzmöglichkeiten sind jedoch ebenfalls denkbar, beispielsweise im Architekturbereich. Hier könnte ein solcher Reflektor dazu dienen, Sonnenlicht in Innenräume "umzulenken":
Weitere bevorzugte Ausführungsformen der Erfindung ergeben sich aus den weiteren Unteransprüchen sowie aus dem nachfolgend näher beschriebenen Ausführungsbeispiel.

Die Erfindung wird nun anhand eines Ausführungsbeispiels mit Bezug auf die Figuren näher erläutert. Hierbei zeigen:
- Figur 1:: eine perspektivische Darstellung eines Ausführungsbeispiels einer erfindungsgemäßen Anordnung,
- Figur 2:: das in Figur 1 Gezeigte in einer Draufsicht aus Richtung R1 (aus der Vertikatrichtung),
- Figur 3:: eine Draufsicht auf das in Figur 1 Gezeigte aus Richtung R2 (das entspricht - bezogen auf die Nordhalbkugel - einer Draufsicht aus Richtung Westen)

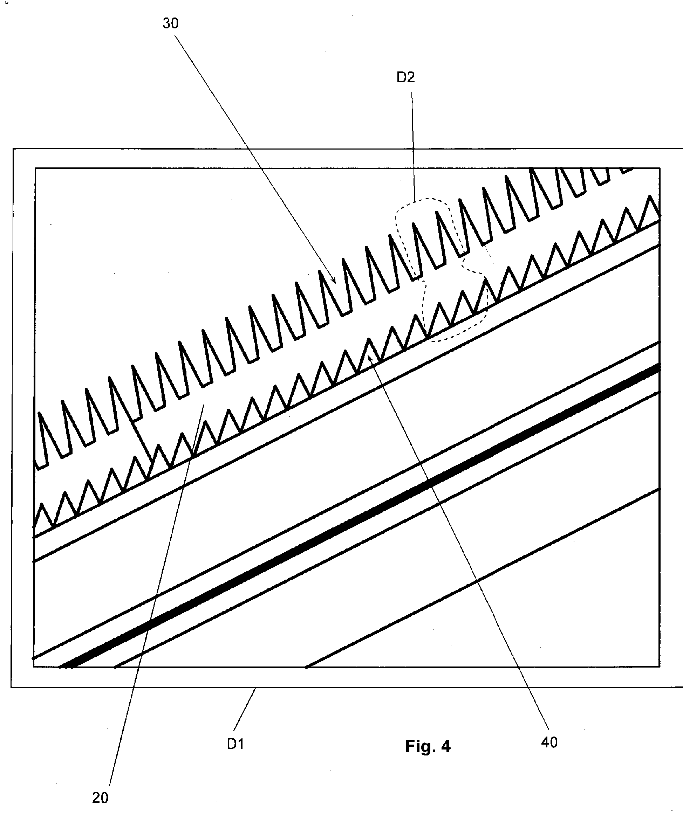

- Figur 4:: das Detail D1 aus Figur 3
- Figur 5:: das Detail D2 aus Figur 4 und

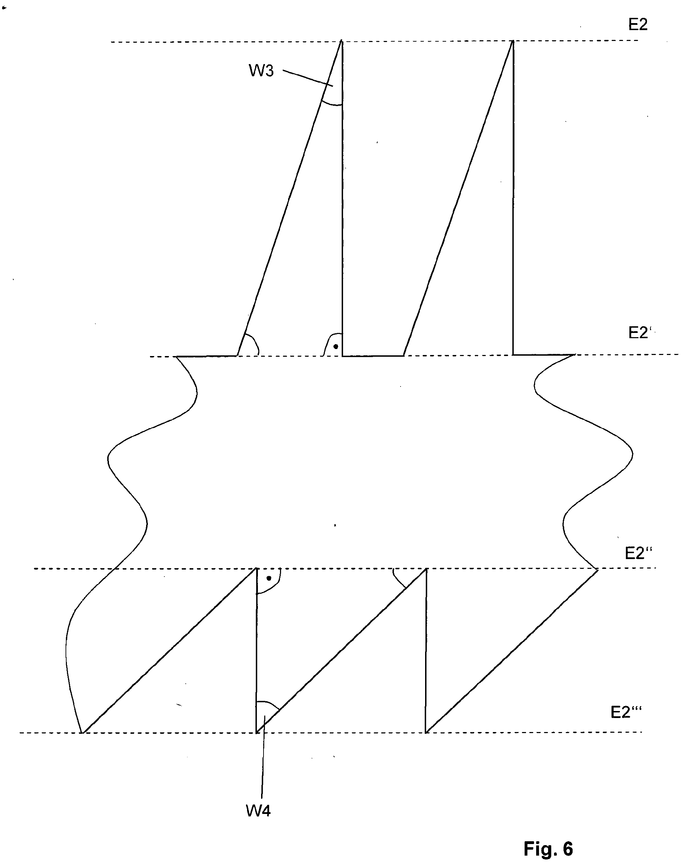

- Figur 6:: das in Figur 5 Gezeigte in einer verkippten Darstellung.

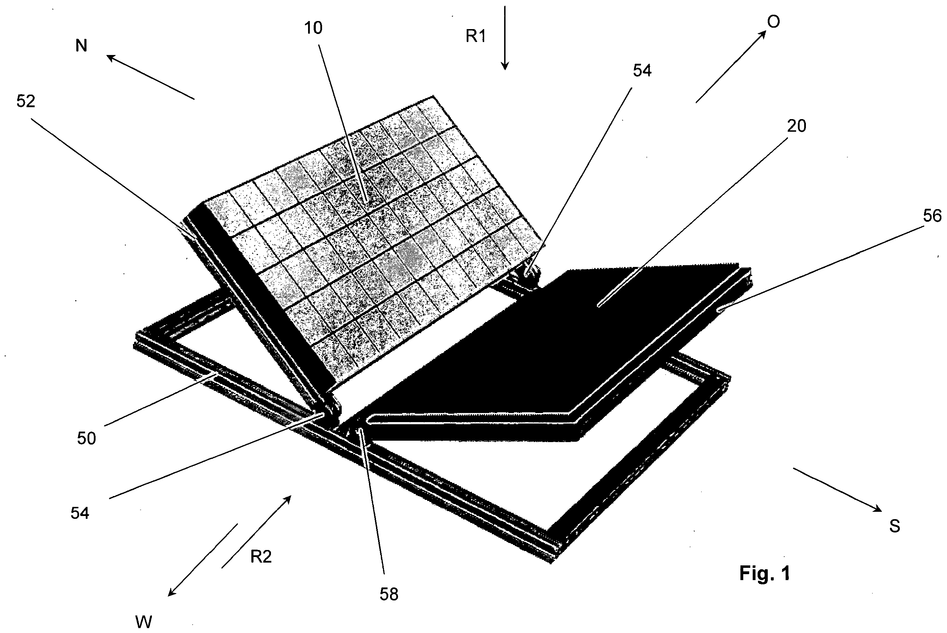

Die Figur 1 zeigt eine als eine Einheit ausgeführte erfindungsgemäße Anordnung. Hierbei ist zunächst zu bemerken, dass die erfindungsgemäße Anordnung bevorzugt in einer solchen Einheit ausgeführt sein kann, insbesondere da sie sich so leicht montieren und justieren lässt; zwingend ist die Ausführung als solche Einheit jedoch nicht, insbesondere können das Solarmodul und der Reflektor völlig voneinander getrennt an einem Untergrund befestigt sein.

Die Anordnung (hier die Einheit) besteht aus dem eben erwähnten Solarmodul 10 und aus einem Reflektor 20, wobei Solarmodul und Reflektor jeweils an einem Rahmen 50 gehalten sind. Die Verbindung zwischen Solarmodul 10 und Rahmen 50 erfolgt über erste Scharniere 54 und die Verbindung zwischen Reflektor 20 und Rahmen 50 erfolgt über zweite Scharniere. Hierbei ist diese Verbindung nur mittelbar, da das Solarmodul 10 an einem ersten Träger 52 und der Reflektor 20 an einem zweiten Träger 56 gehalten ist. Die Schwenkachsen der beiden Scharniere 54, 58 sind parallel zueinander und erstrecken sich in dem Zustand, in welchem der Rahmen 50 fest mit einem Untergrund (beispielsweise einem Dach) befestigt ist, in Ost-West-Richtung.

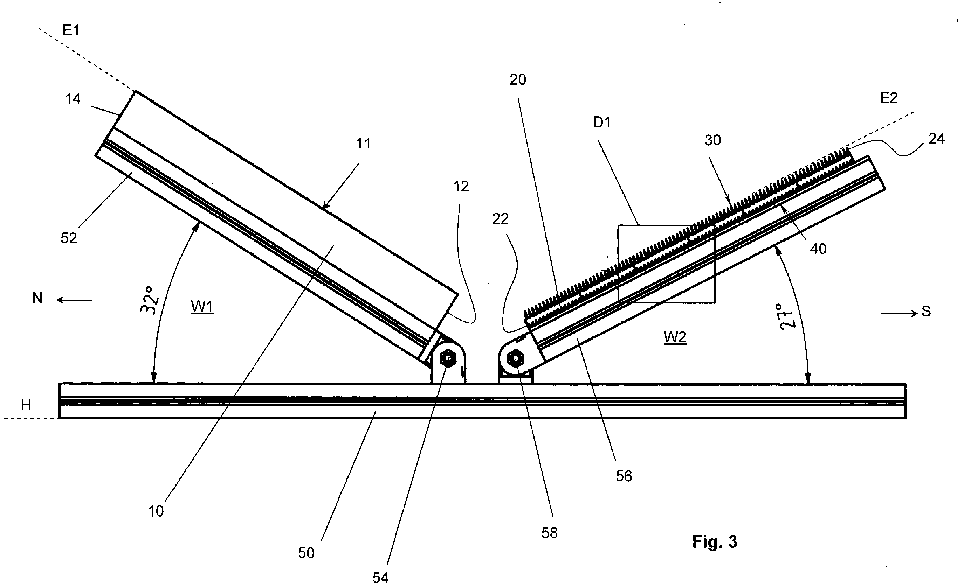

Beim Solarmodul 10 kann es sich insbesondere um ein Photovoltaik-Solarmodul mit einer Oberfläche 11 handeln, wobei diese Oberfläche mit der Horizontalen H einen ersten Winkel W1 einschließt (siehe hierzu insbesondere Figur 3). Das Solarmodul 10 erstreckt sich von einem oberen Ende 14 (dem nördlichen Ende) zum unteren Ende (dem südlichen Ende). Der bereits erwähnte Reflektor 20 erstreckt sich vom gerade erwähnten unteren Ende 12 von seinem ersten (unteren) Ende 22 in südlicher Richtung zu seinem zweiten (oberen) Ende 24. Auch der Reflektor 20 definiert als Ganzes eine Ebene (oder mehrere zueinander parallele Ebenen, wie man später sehen wird), wobei diese Ebene ebenfalls gegen die Horizontale geneigt ist und zwar um den Winkel W2. Im gezeigten Ausführungsbeispiel beträgt der erste Winkel W1 32° Grad und der zweite Grad W2 27° Grad. In dieser Anmeldung wird immer auf die eingeschlossenen Winkel kleiner 90° Bezug genommen, unabhängig von der Orientierung.

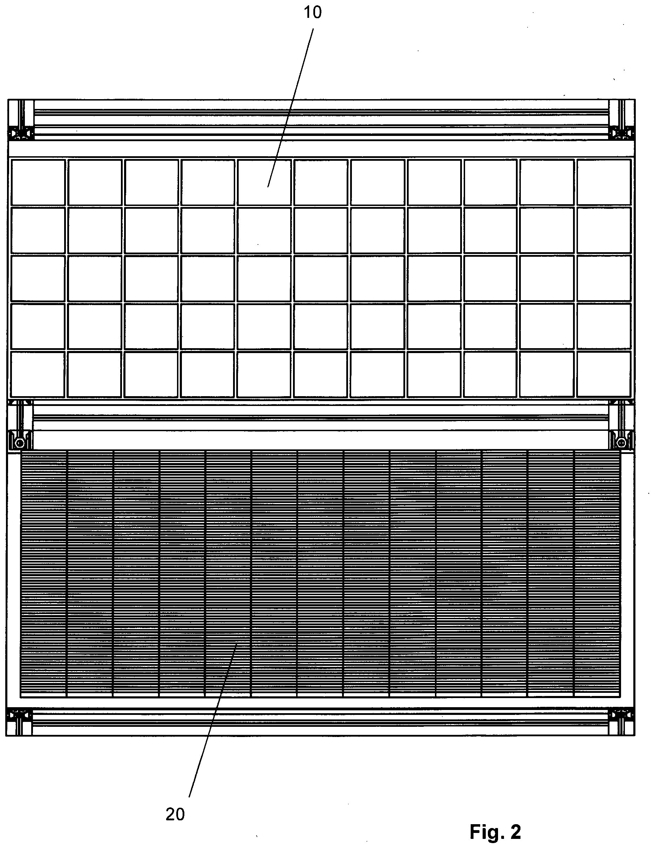

Es wird nun auf den Reflektor 20 eingegangen. Dieser Reflektor könnte grundsätzlich einstückig ausgeführt sein, aus Herstellungsgründen ist es in der Regel jedoch zu bevorzugen, ihn aus zahlreichen, jeweils einstückigen, nebeneinander angeordneten Reflektorelementen zusammenzusetzen, wie dies in Figur 2 auch angedeutet ist; für das im Weiteren Beschriebene spielt dies jedoch keine Rolle. Der Reflektor 20 besteht aus einem durchsichtigen Material, insbesondere aus einen durchsichtigen Kunststoff wie PMMA oder PC und hat hierbei einen Brechungsindex von typischerweise ca. 1,5. Jedes Reflektorelement ist vorzugsweise ein einstückiges Kunststoff-Spritzgussteil.

Der Reflektor 20 hat eine obere Oberfläche 30 und eine untere Oberfläche 40. Beide Oberflächen 30, 40 sind gerippt mit einer Vielzahl von Rippen ausgebildet, wobei die Rippen der oberen Oberfläche 30 als erste Rippen 32 und die Rippen der unteren Oberfläche 40 als zweite Rippen 42 bezeichnet sind. Es ist zu bevorzugen, dass alle ersten Rippen 32 identisch zueinander sind und dass alle zweiten Rippen 42 identisch zueinander sind. Absolut zwingend ist dies jedoch nicht. Beispielsweise wäre es denkbar, alternierend zueinander zwei erste Rippentypen mit unterschiedlicher Querschnittsform oder auch mit unterschiedlicher Höhe einzusetzen. Es ist jedoch zu erwarten, dass sich ein idealer Effekt dann ergibt, wenn alle ersten Rippen und alle zweiten Rippen jeweils identisch zueinander sind. Die untere Oberfläche ist vorzugsweise verspiegelt, beispielsweise mittels einer von außen aufgedampften Metallschicht.

Die ersten Rippen 32 und die zweiten Rippen 42 sind jeweils prismenförmig, nämlich mit dreieckigen Querschnitten ausgebildet, sodass sich jeweils ein Sägezahnprofil ausbildet. Im gezeigten Ausführungsbeispiel sind benachbarte erste Rippen 32 voneinander beabstandet, so dass sich zwischen zwei ersten Rippen 32 jeweils eine Zwischenfläche 38 ergibt. Die Ausbildung der Rippen - insbesondere der ersten Rippen 32 - mit einem dreieckigen Querschnitt ist zu bevorzugen, jedoch wären auch Ausführungsformen mit abgeschnittenen Ecken (sodass sich schief-trapez-förmige Querschnitte ergeben) möglich, jedoch nicht bevorzugt. Die erste und die zweite Oberfläche einer ersten Rippe schließen einen dritten Winkel W3 und die dritte und die vierte Oberfläche einer zweiten Rippe schließen einen vierten Winkel W4 ein.

Zwischen den ersten Rippen 32 und den zweiten Rippen 42 befindet sich ein Mittelabschnitt 25, welcher plattenförmig in folgendem Sinne ausgebildet ist: Würde man die ersten Rippen 32 und die zweiten Rippen 42 eben absägen, so ergäbe sich eine ebene Platte. Die Gesamtdicke des Reflektors (einschließlich der Rippen) liegt im gezeigten Ausführungsbeispiel in der Größenordnung von einem bis zwei Zentimeter.

Im Folgenden wird noch auf die Definition der zweiten Ebene (die Ebene des Reflektors 20) eingegangen: Es ist offensichtlich, dass der Reflektor 20 als Ganzes eine Ebenenrichtung definiert, wobei eine entsprechende Ebene beispielsweise durch die Spitzen oder Basen der ersten Rippen 32 oder die Spitzen oder die Basen der zweiten Rippen 42 definiert sein kann. All diese Ebenen sind parallel zueinander, jedoch voneinander beabstandet, d.h. sie bilden eine Ebenenschar E, E', E", E"'.

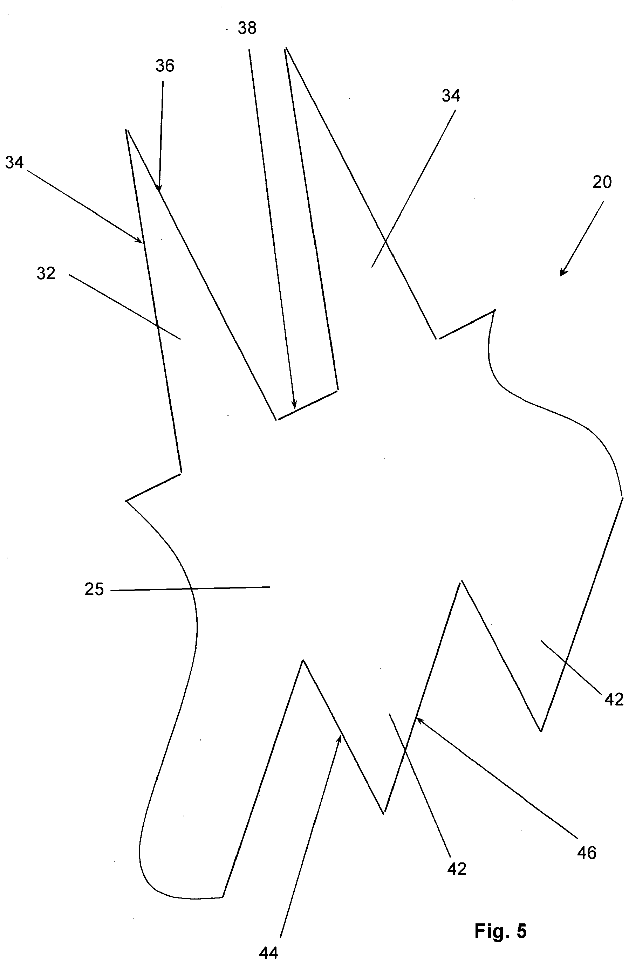

Bevorzugte Geometrien (Winkelbereiche) sind nun mit Bezug auf die Figur 5 angegeben: Die zweiten Oberflächen der ersten Rippen stehen relativ steil, vorzugsweise in einem 90°-Winkel auf die zweite Ebene E2, ebenso die vierten Oberflächen der zweiten Rippen. Die ersten Oberflächen der ersten Rippen und die zweiten Oberflächen der zweiten Rippen stehen entsprechend flacher zur zweiten Ebene E2. Der dritte Winkel W3 beträgt im gezeigten Ausführungsbeispiel 20°.

Wie dies bereits erwähnt wurde, erstrecken sich sämtliche Rippen 32, 42 parallel zueinander, nämlich insbesondere in Ost-West-Richtung.

Es wird nun die Wirkungsweise des Reflektors erläutert. Die Erläuterung der Wirkungsweise kann hier nur recht schematisch erfolgen, da sich eine große Menge unterschiedlicher Strahlengänge ergeben, welche sich nur durch Computersimulationen im Detail berechnen lassen und welche mit den Mitteln einer Patentanmeldung praktisch nicht sinnvoll darstellbar sind. Die Wirksamkeit der erfindungsgemäßen Anordnung (d.h. auch des erfindungsgemäßen Reflektors) wurde jedoch erprobt und es konnten erhebliche "Tages-Mehrausbeuten" von 30% und mehr im Vergleich zu einem Solarmodul ohne einen solchen Reflektor gemessen werden.

Trifft das Sonnenlicht (insbesondere in den Morgen- und Abendstunden) mit einem relativ großen Ost-West- oder West-Ost-Richtungsanteil auf die obere Oberfläche 30 des Reflektors 20, so gelangt ein Großteil des Lichtes durch Brechung zunächst ins Innere des Reflektors 20. Aus den bekannten Gesetzen der Strahlenoptik folgt, dass nur ein recht geringer Anteil des auftreffenden Lichts im einstelligen Prozentbereich direkt reflektiert wird. Das einmal eingefangene Licht hat nun nur relativ wenige Möglichkeiten den Reflektor 20 wieder zu verlassen, wobei hier der einfachere (und auch bevorzugte) Fall betrachtet wird, in welchem die untere Oberfläche 40 verspiegelt ist. In diesem Fall kann das Licht den Reflektor 20 (außer eventuell an den Stirnkanten, was jedoch vernachlässigbar ist) nur an der oberen Oberfläche 30 verlassen, wobei sich auf Grund der gerippten Form der oberen Oberfläche 30 eine starke Ausrichtung des Lichtes in Richtung Solarmodul ausbildet. Somit wäre eine geeignete Bezeichnung für das Bauteil, welches hier als Reflektor bezeichnet wird, auch "Lichtausrichter" oder "Lichtumlenker".

Den Grund, warum eine so gute Lichtausrichtung in Richtung des Solarmoduls erfolgt, kann man der Figur 5 unmittelbar (zumindest qualitativ) entnehmen: Wie dies bereits erwähnt wurde, kann das Licht den Reflektor 20 praktisch nur über dessen obere Oberfläche 30 verlassen. Hier gibt es drei Möglichkeiten, nämlich dass das Licht den Reflektor an einer ersten Oberfläche 34 einer ersten Rippe 32, an einer zweiten Oberfläche 36 einer ersten Rippe oder an einer Zwischenfläche 38 verlässt. Hierbei ist jedoch folgendes zu beachten: der Winkelbereich, unter welchem Licht die Zwischenfläche 38 verlassen kann, ohne wieder in den Reflektor einzutreten, ist relativ klein. Dieser Betrag wird umso kleiner, je höher die ersten Rippen 32 im Verhältnis zu ihrem Abstand sind, weshalb es zu bevorzugen ist, dass die Höhe der ersten Rippen 32 wenigstens das Doppelte ihres Abstands voneinander beträgt. Im gezeigten bevorzugten Ausführungsbeispiel ist dieser Wert wesentlich größer; hier ist die Höhe der ersten Rippen 32 um etwa den Faktor 5 größer als ihr Abstand voneinander.

Betrachtet man nun die zweiten Oberflächen 36, so sieht man, dass sämtliches Licht, welches senkrecht aus einer zweiten Oberfläche 36 austritt, wieder auf eine erste Oberfläche 34 einer benachbarten ersten Rippe 32 trifft und auf Grund der Schräge der ersten Oberfläche 34 wieder in den Reflektor 20 hinein gebrochen wird (bis auf den kleinen reflektierten Anteil). Es kann somit nur ein sehr kleiner Anteil des Lichts durch Austritt aus einer zweiten Oberfläche 36 den Reflektor 20 endgültig verlassen.

Abschließend werden die ersten Oberflächen 34 der ersten Rippen 32 betrachtet. Der Einfachheit halber werden auch hier nur senkrecht austretende Lichtstrahlen betrachtet: man sieht hier, dass zumindest in einem oberen Bereich der ersten Rippen 32 Licht unter einem rechten Winkel derart austreten kann, dass das Licht den Reflektor endgültig in Richtung des Solarmodules 10 verlässt. Auf Grund der Schrägstellung des Reflektors 20 hat es hierbei auch noch eine nach unten weisenden Richtungsanteil (ähnlich wie Sonnenlicht), sodass es in einem recht günstigen Winkel auf das Solarmodul 10 auftrifft.

Schon allein durch die obigen stark vereinfachten und qualitativen Überlegungen sieht man, dass der Reflektor 20 eine Umlenkung des Sonnenlichts in eine Vorzugsrichtung in Richtung des Solarmoduls 10 bewirkt. Eine vollständige quantitative Analyse ist auf Grund der großen Komplexität des mathematischen Problems im Rahmen einer Patentanmeldung kaum möglich, der Effekt lässt sich durch Messungen jedoch leicht nachweisen.

Abschließend sei noch folgendes bemerkt: Eine asymmetrische Ausgestaltung der ersten Rippen 32 dahingehend, dass die zweiten Oberflächen 36 steiler zur Ebene E2 des Reflektors 20 stehen (im gezeigten Ausführungsbeispiel senkrecht), als die ersten Oberflächen 34, ist natürlich zu bevorzugen, da, wie dies oben dargelegt wurde, hieraus folgt, dass mehr Licht in Richtung des Reflektors 20 abgestrahlt wird als in die Gegenrichtung. Es sei jedoch noch erwähnt, dass sich selbst bei einer symmetrischen Ausführung der ersten Rippen 32 ein Effekt erzielen lässt, da natürlich auch dann schon zusätzliches Sonnenlicht auf das Solarmodul gelangt.

### Bezugszeichenliste

- 10: Solarmodul
- 11: Oberfläche
- 12: unteres Ende
- 14: oberes Ende
- 20: Reflektor
- 22: erstes (unteres) Ende
- 24: zweites (oberes) Ende
- 25: Mittelabschnitt
- 30: obere Oberfläche
- 32: erste Rippen
- 34: erste Oberfläche
- 36: zweite Oberfläche
- 38: Zwischenfläche
- 40: untere Oberfläche
- 42: zweite Rippen
- 44: dritte Oberfläche
- 46: vierte Oberfläche
- 50: Rahmen
- 52: erster Träger
- 54: erstes Scharnier
- 56: zweiter Träger
- 58: zweites Scharnier
- E1: erste Ebene
- E2: zweite Ebene
- H: Horizontalebene
- W1: erster Winkel
- W1: erster Winkel
- W2: zweiter Winkel
- W3: dritter Winkel
- W4: vierter Winkel

## Patentansprüche

1. Anordnung zur Nutzung von Sonnenenergie mit
einem flächigen, im Wesentlichen ebenen Solarmodul (10) zur Umwandlung von Sonnenstrahlung in eine Nutzenergie, wobei die Oberfläche (11) des Solarmoduls (10) eine erste Ebene (E1) definiert, welche gegen die Horizontale (H) um einen ersten Winkel (W1) geneigt ist, so dass das Solarmodul (10) ein oberes Ende (14) und ein unteres Ende (12) aufweist, wobei benachbart zum unteren Ende (12) des Solarmoduls (10) ein aus einem durchsichtigen Material bestehender Reflektor (20) angeordnet ist, welcher sich von einem dem unteren Ende (12) des Solarmoduls (10) benachbarten ersten Ende (22) vom Solarmodul (10) weg erstreckt, wobei
- der Reflektor (20) eine nach oben weisende obere Oberfläche (30) und eine nach unten weisende untere Oberfläche (40) aufweist,
- wobei die obere Oberfläche (30) gerippt mit einer Mehrzahl von ersten Rippen (32) ausgebildet ist, wobei jede erste Rippe (32) eine dem Solarmodul zugewandte erste Oberfläche (34) und eine dem Solarmodul abgewandte zweite Oberfläche (36) aufweist,
**dadurch gekennzeichnet, dass** die untere Oberfläche (40) gerippt mit einer Mehrzahl von zweiten Rippen (42) ausgebildet ist, wobei die zweiten Rippen (42) jeweils eine dritte Oberfläche (44) und eine vierte Oberfläche (46) aufweisen, welche jeweils einen vierten Winkel (W4) miteinander einschließen,

2. Anordnung nach Anspruch 1, **dadurch gekennzeichnet, dass** die zweiten Rippen (42) vorzugsweise einen dreieckigen Querschnitt aufweisen.

3. Anordnung nach Anspruch 1, **dadurch gekennzeichnet, dass** der Reflektor (20) eine zweite Ebene (E2) definiert, welche um einen zweiten Winkel (W2) gegen die Horizontale (H) geneigt ist, wobei der Betrag des zweiten Winkels (W2) vorzugsweise höchstens so groß wie der Betrag des ersten Winkels (W1) ist.

4. Anordnung nach einem der vorangehenden Ansprüche, **dadurch gekennzeichnet, dass** die ersten Oberflächen (34) eben sind und sich parallel zueinander erstrecken.

5. Anordnung nach einem der vorangehenden Ansprüche, **dadurch gekennzeichnet, dass** die zweiten Oberflächen (36) eben sind und sich parallel zueinander erstrecken.

6. Anordnung nach einem der vorangehenden Ansprüche, **dadurch gekennzeichnet, dass** die erste Oberfläche (34) und die zweite Oberfläche (36) einer ersten Rippe (32) einen dritten Winkel (W3) miteinander einschließen, wobei die ersten Rippen (32) vorzugsweise einen dreieckigen Querschnitt aufweisen.

7. Anordnung nach Anspruch 6, **dadurch gekennzeichnet, dass** der dritte Winkel zwischen 15° und 25° beträgt.

8. Anordnung nach Anspruch 3 und Anspruch 6 oder Anspruch 7, **dadurch gekennzeichnet, dass** die zweite Oberfläche (36) stärker gegen die zweite Ebene (E2) geneigt ist als die erste Oberfläche (34), wobei die zweite Oberfläche (36) vorzugsweise im Wesentlichen senkrecht zur zweiten Ebene (E2) steht.

9. Anordnung nach einem der vorangehenden Ansprüche, **dadurch gekennzeichnet, dass** die Höhe der ersten Rippen (32) mindestens dreimal größer als der Abstand von zwei benachbarten ersten Rippen (32) voneinander ist.

10. Anordnung nach einem der vorangehenden Ansprüche, **dadurch gekennzeichnet, dass** sich alle Rippen (32, 42) entlang einer Richtung erstrecken.

11. Anordnung nach einem der vorangehenden Ansprüche, **dadurch gekennzeichnet, dass** der Reflektor (20) aus PMMA oder Polycarbonat besteht.

12. Anordnung nach einem der vorangehenden Ansprüche, **dadurch gekennzeichnet, dass** der Reflektor (20) aus mehreren identischen Reflektorelementen besteht.

13. Anordnung nach einem der vorangehenden Ansprüche, **dadurch gekennzeichnet, dass** die untere Oberfläche (40) verspiegelt ist.

## Claims

1. Assembly for using solar energy, with a two-dimensional, essentially flat solar module (10) for converting solar energy into a useful energy, wherein the surface (11) of the solar module (10) defines a first plane (E1), which is inclined against the horizontal (H) by a first angle (W1) such that the solar module (10) comprises an upper end (14) and a lower end (12),
wherein a reflector (20) consisting of a transparent material is arranged adjacent to the lower end (12) of the solar module (10), the said reflector extending away from the solar module (10), from a first end (22) adjacent to the lower end (12) of the solar module (10), wherein
- the reflector (20) comprises a surface (30) pointing upwards and a surface (40) pointing downwards,
- wherein the upper surface (30) is configured as ribbed with a plurality of first ribs (32), wherein each first rib (32) comprises a first surface (34) facing towards the solar module, and a second surface (36) facing away from the solar module,
**characterized in that** the lower surface (40) is configured as ribbed with a plurality of second ribs (42), wherein the second ribs (42) in each case comprise a third surface (44) and a fourth surface (46), which in each case enclose a fourth angle (W4) to one another.

2. Assembly according to claim 1, **characterized in that** the second ribs (42) preferably comprise a triangular cross-section.

3. Assembly according to claim 1, **characterized in that** the reflector (20) defines a second plane (E2), which is inclined by a second angle (W2) against the horizontal (H), wherein the amount of the second angle (W2) is preferably at the most as great as the amount of the first angle (W1).

4. Assembly according to any one of the preceding claims, **characterized in that** the first surfaces (34) are flat and extend parallel to one another.

5. Assembly according to any one of the preceding claims, **characterized in that** the second surfaces (36) are flat and extend parallel to one another.

6. Assembly according to any one of the preceding claims, **characterized in that** the first surface (34) and the second surface (36) of a first rib (32) enclose a third angle (W3) with one another, wherein the first ribs (32) preferably exhibit a triangular cross-section.

7. Assembly according to claim 6, **characterized in that** the third angle amounts to between 15° and 25°.

8. Assembly according to claim 3 and claim 6 or claim 7, **characterized in that** the second surface (36) is inclined more steeply against the second plane (E2) than the first surface (34), wherein the second surface (36) preferably stands essentially perpendicular to the second plane (E2).

9. Assembly according to any one of the preceding claims, **characterized in that** the height of the first ribs (32) is at least three times greater than the distance of two adjacent first ribs (32) from one another.

10. Assembly according to any one of the preceding claims, **characterized in that** all the ribs (32, 42) extend along one direction.

11. Assembly according to any one of the preceding claims, **characterized in that** the reflector (20) consists of PMMA or polycarbonate.

12. Assembly according to any one of the preceding claims, **characterized in that** the reflector (20) consists of a plurality of identical reflector elements.

13. Assembly according to any one of the preceding claims, **characterized in that** the lower surface is mirrored (40).

## Revendications

1. Système pour l'utilisation de l'énergie solaire comprenait un module solaire (10) de face, sensiblement plan, pour la transformation du rayonnement solaire en une énergie utilisable, la surface (11) du module solaire (10) définissant un premier plan (E1) qui est incliné d'un premier angle (W1) par rapport à l'horizontale (H) de sorte que le module solaire (10) présente une extrémité supérieure (14) et une extrémité inférieure (12),
dans lequel un réflecteur (20) composé d'un matériau transparent est agencé de manière adjacente à l'extrémité inférieure (12) du module solaire (10), ledit réflecteur tendant à partir d'une première extrémité (22) voisine de l'extrémité inférieure (12) du module solaire (10), dans lequel
- le réflecteur (20) présente une surface supérieure (30) tournée vers le haut et une surface inférieure (40) tournée vers le bas,
- la surface supérieure (30) est striée avec une pluralité de premières nervures (32) qui présentant chacune une première surface (34) tournée vers le module solaire et une deuxième surface (36) tournée à l'opposé du module solaire,
**caractérisé en ce que** la surface inférieure (40) est striée avec une pluralité de deuxièmes nervures (42) qui présentent chacune une troisième surface (44) et une quatrième surface (46) formant l'une par rapport à l'autre un quatrième angle (W4).

2. Système selon la revendication 1, **caractérisé en ce que** les deuxièmes nervures (42) présentent de préférence une section transversale triangulaire.

3. Système selon la revendication 1, **caractérisé en ce que** le réflecteur (20) définit un deuxième plan (E2) qui est incliné d'un deuxième angle (W2) par rapport à l'horizontale (H), dans lequel la valeur du deuxième angle (W2) est de préférence, au maximum, égale à la valeur du premier angle (W1).

4. Système selon l'une des revendications précédentes, **caractérisé en ce que** les premières surfaces (34) sont planes et s'étendent parallèlement les unes aux autres.

5. Système selon l'une des revendications précédentes, **caractérisé en ce que** les deuxièmes surfaces (36) sont planes et s'étendent parallèlement les unes aux autres.

6. Système selon l'une des revendications précédentes, **caractérisé en ce que** la première surface (34) et la deuxième surface (36) d'une première nervure (32) forment l'une par rapport à l'autre un troisième angle (W3), les premières nervures (32) présentant de préférence une section transversale triangulaire.

7. Système selon la revendication 6, **caractérisé en ce que** le troisième angle est compris entre 15° et 25°.

8. Système selon la revendication 3 et la revendication 6 ou 7 **caractérisé en ce que** la deuxième surface (36) est plus fortement inclinée par rapport au deuxième plan (E2) que la première surface (34), la deuxième surface (36) étant de préférence sensiblement perpendiculaire au deuxième plan (E2).

9. Système selon l'une des revendications précédentes, **caractérisé en ce que** la hauteur des premières nervures (32) est au moins trois fois plus grande que l'écartement de deux premières nervures (32) voisines, l'une de l'autre.

10. Système selon l'une des revendications précédentes, **caractérisé en ce que** toutes les nervures (32, 42) s'étendent selon une direction.

11. Système selon l'une des revendications précédentes, **caractérisé en ce que** le réflecteur (20) est constitué de PMMA ou de polycarbonate.

12. Système selon l'une des revendications précédentes, **caractérisé en ce que** le réflecteur (20) est constitué de plusieurs éléments réflecteurs identiques.

13. Système selon l'une des revendications précédentes, **caractérisé en ce que** la surface inférieure (40) est réflectorisée.
